# EUROPÄISCHE PATENTSCHRIFT

(11) **EP 3 229 567 B1**
(45) Veröffentlichungstag und Bekanntmachung des Hinweises auf die Patenterteilung: **19.06.2019**
(21) Anmeldenummer: 16164028.9
(22) Anmeldetag: 06.04.2016
(51) Int. Cl.: H05K 5/02, H05K 5/03, H05K 7/14

(54) **ELEKTRONISCHE BAUGRUPPE DER AUTOMATISIERUNGSTECHNIK**
ELECTRONIC AUTOMATION TECHNOLOGY MODULE
MODULE ELECTRONIQUE DE LA TECHNIQUE D'AUTOMATISATION

(43) Veröffentlichungstag der Anmeldung: 11.10.2017
(73) Patentinhaber: Siemens Aktiengesellschaft, 80333 München (DE)
(72) Erfinder: Bergmann, Martin, 92253 Schnaittenbach (DE); Forster, Tobias, 92421 Schwandorf (DE)

(56) Entgegenhaltungen:
- EP-A1- 2 688 379
- DE-A1- 19 822 564
- DE-A1-102010 047 632
- US-A1- 2011 222 260

## Beschreibung

Die Erfindung betrifft eine elektronische Baugruppe der Automatisierungstechnik mit einem Gehäuse, einer Rückseite und einer Vorderseite, wobei die Rückseite mit Haltemitteln zum Befestigen an einem Tragsystem ausgestaltet ist und an der Vorderseite ein mit dem Gehäuse verbundener beweglicher Deckel angeordnet ist, wobei in einem oberen Bereich der Vorderseite des Gehäuses eine Aufnahme angeordnet ist, wobei die Aufnahme ausgestaltet ist, ein erstes Scharnierteil eines das Gehäuse und den Deckel verbindenden Scharniers mit einem Verrastmechanismus aufzunehmen, der Deckel ist dabei an einem ersten Ende als ein zweites Scharnierteil des Scharniers ausgestaltet und zur Ausbildung des zweiten Scharnierteils weist er eine erste Lasche und eine zweite Lasche auf, wobei in der ersten Lasche eine Welle drehfest angeordnet ist. Unter Tragsystem ist beispielsweise eine Hutschiene zu verstehen.

Aus der Veröffentlichungsschrift EP 2 688 379 A1 ist eine ähnliche elektronische Baugruppe der Automatisierungstechnik bekannt. Von Nachteil ist es bei der bekannten Baugruppe, das ein Drehmoment an dem beweglichen Deckel der Baugruppe durch einen aufwändig konstruierten und teuer herzustellenden Achskörper realisiert wird. Zudem ist nachteilig, das bei diesem derzeit bekannten Achskörper der benötigte Einbauraum für den Achskörpert zu groß ausfällt und dadurch eine Montage einer flexiblen Flachleitung, welche in den Deckel hineinführen soll, erschwert ist.

Es ist Aufgabe der vorliegenden Erfindung eine konstruktive Lösung zu finden, welche in dem aufklappbaren Deckel bzw. in seinen zweiten Scharnierteilen weniger Platz braucht.

Die Aufgabe wird bei der eingangs genannten elektronischen Baugruppe dadurch gelöst, dass der erste Scharnierteil eine erste Gegenlasche und eine zweite Gegenlasche aufweist, und die erste Gegenlasche einen ersten Zapfen aufweist, welcher in einer Bohrung der Welle angeordnet ist, weiterhin weist die zweite Gegenlasche eine Ausnehmung auf, in die ein zweiter Zapfen der zweiten Lasche angeordnet ist, wobei ein Federelement im ersten Scharnierteil angeordnet ist, wobei das Federelement die Welle umschließt, wobei das Federelement zur Ausbildung eines Drehmomentes beim Öffnen des Deckels und zur Erreichung von Öffnungsstellungen derart ausgebildet ist, dass es eine erste Wellenauflage und eine zweite Wellenauflage aufweist, welche je nach Stellung des Deckels auf die Welle Druck ausüben oder in Vertiefungen in der Welle greifen.

Das neue Scharnier wird erfindungsgemäß durch ein Zusammenspiel von dem Federelement und der Welle mit Vertiefungen erreicht. Das Zusammenspiel der Welle und des Federelementes mit seinen Wellenauflagen ermöglicht das nötige Drehmoment zu erreichen. Eine Anzahl von Raststellen kann durch die Anzahl der Vertiefungen in der Welle variiert werden. Die Welle ist fest z.B. mit einem Kunststoffteil, nämlich der ersten Lasche des Deckels verbunden.

Durch den Gewinn an Bauraum kann die flexible Flachleitung im Scharnier direkt durch den Drehpunkt geführt werden. Die flexible Flachleitung muss nicht mehr, wie im bekannten Stand der Technik EP 2 688 379 A1, um den Drehpunkt herum geschlungen werden. Bei verschiedenen Stellungen des Deckels erfolgt bei der flexiblen Flachleitung ein "Flügelschlag", so dass ein Längenausgleich nicht mehr benötigt wird. Daraus erwachsen die Vorteile einer einfacheren Montage und eine Automatisierbarkeit der Montage ist damit gewährleistet.

Um die Flachleitung bei einem Öffnen des Deckels sicher zu führen, ist in einer vorteilhaften Ausgestaltung der Deckel in einen ersten Deckelteil und in einen zweiten Deckelteil aufgeteilt, wobei die Deckelteile mittels Verraststellen zum Bilden des Deckels miteinander verrasten, wobei am zweiten Deckelteil zwischen der ersten Lasche und der zweiten Lasche ein Spanner mit konvexer Gleitfläche zum Führen einer flexiblen Flachleitung angeordnet ist, weiterhin ist am ersten Deckelteil eine Umhausung für den Spanner und die Flachleitung angeordnet.

Weiterhin ist es vorteilhaft, wenn der erste Scharnierteil einen Oberteil und einen Unterteil umfasst, wobei die erste Gegenlasche und die zweite Gegenlasche am Oberteil angeordnet sind und der Unterteil einen Stauraum für die Flachleitung aufweist.

Im Hinblick auf ein erzeugendes Drehmoment und auf das Bereitstellen von Raststellen bei offenen, stehenden Deckel, ist es von Vorteil, wenn das Federelement aus einem flächigen Federmaterial in der Form eines Omegas gebogen ist.

Besonders vorteilhaft ist es, wenn die erste Wellenauflage und die zweite Wellenauflage des Federelementes als S-förmige Knickstellen in dem flächigen Federmaterial ausgebildet sind.

In einem Ausführungsbeispiel werden weitere Details und vorteilhafte Merkmale erläutert. Die Zeichnung zeigt daher ein mögliches Ausführungsbeispiel der elektronischen Baugruppe mit einem Deckel, dabei zeigt die
- FIG 1: eine schematische, perspektivische Ansicht einer elektronischen Baugruppe,
- FIG 2: eine schematische, perspektivische Ansicht einer elektronischen Baugruppe mit einem Deckel, welcher über einen Scharnierteil in das Gehäuse der elektronischen Baugruppe eingesteckt werden kann,
- FIG 3: eine perspektivische Ansicht des ersten und des zweiten Scharnierteils in einer Schnittdarstellung bei einer 0°-Stellung,
- FIG 4: eine perspektivische Ansicht des ersten und des zweiten Scharnierteils in einer Schnittdarstellung bei einer 90°-Stellung,
- FIG 5: eine perspektivische Ansicht des ersten und des zweiten Scharnierteils in einer Schnittdarstellung bei einer 180°-Stellung,
- FIG 6: eine dreidimensionale Ansicht in einer Explosionsdarstellung des Deckels,
- FIG 7: eine dreidimensionale Ansicht des Deckels,
- FIG 8: eine dreidimensionale Ansicht vom ersten und zweiten Scharnierteil mit Blick auf einen Spanner bei einer 90°-Stellung,
- FIG 9: eine weitere dreidimensionale Ansicht mit Blick auf den Spanner bei einer 0°-Stellung,
- FIG 10: eine weitere dreidimensionale Ansicht um das Zusammenspiel des Spanners und des Stauraumes zu verdeutlichen und die
- FIG 11: nochmals eine andere dreidimensionale Darstellung bei einer 180°-Stellung mit Blick auf den Spanner und den Stauraum um den "Flügelschlag" zu verdeutlichen.

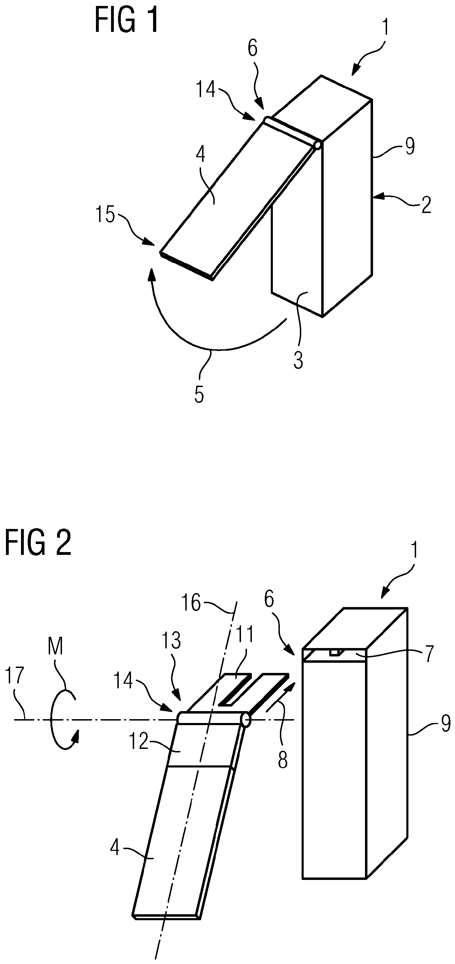

Gemäß FIG 1 ist eine elektronische Baugruppe 1 der Automatisierungstechnik mit einem Gehäuse 9, einer Rückseite 2 und einer Vorderseite 3 dargestellt. In einem oberen Bereich 6 der Vorderseite 3 ist ein Deckel 4 drehbar angeordnet. Der Deckel 4 lässt sich in einer Aufklapprichtung 5 von der elektronischen Baugruppe 1 wegbewegen. Der Deckel 4 weist ein erstes Ende 14 und ein zweites Ende 15 auf.

Gemäß FIG 2 ist die elektronische Baugruppe 1 mit dem Deckel 4 in einer zweigeteilten Darstellung ausgebildet. An seinem ersten Ende 14 weist der Deckel 4 ein Scharnier 13 auf, das Scharnier 13 umfasst ein erstes Scharnierteil 11 und ein zweites Scharnierteil 12. Das erste Scharnierteil 11 ist derart ausgestaltet, dass es in einer Einsteckrichtung 8 in einer Aufnahme 7 des Gehäuses 9 der elektronischen Baugruppe 1 eingesteckt werden kann. An der Stelle wo das erste Scharnierteil 11 und das zweite Scharnierteil 12 zusammenfinden, bildet sich eine Scharnierdrehachse 17.

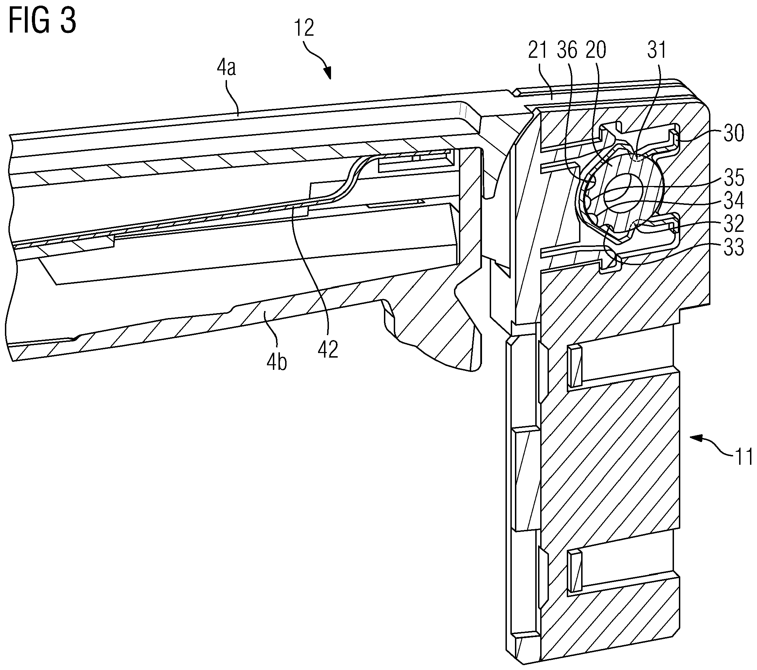

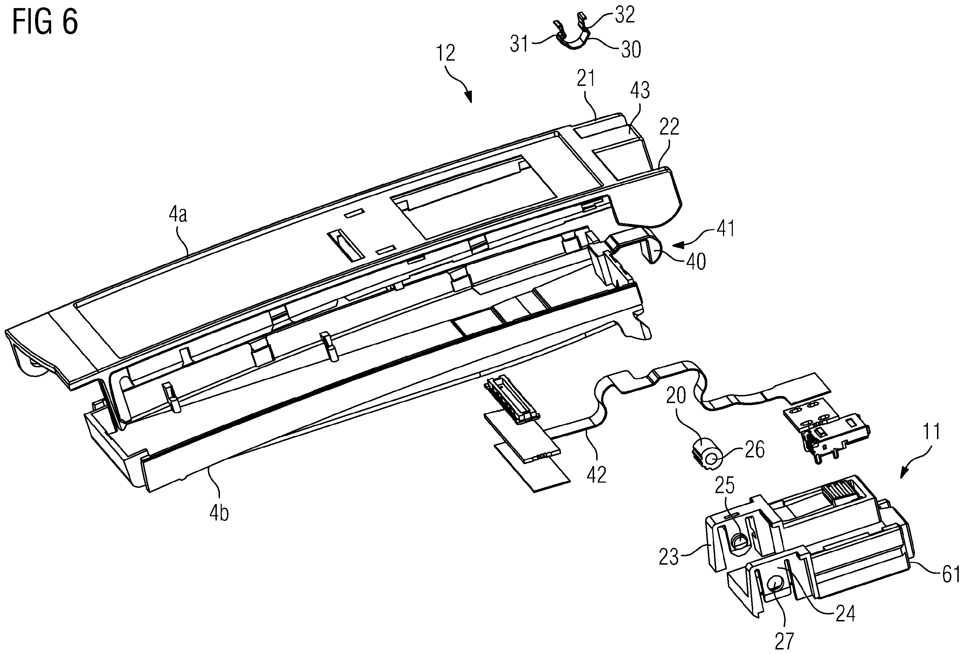

Gemäß den Figuren 3, 4 und 5 sind in einer Ausschnittsdarstellung jeweils das erste Scharnierteil 11 und das zweite Scharnierteil 12 in einer Schnittdarstellung mit Sicht auf die Welle 20 dargestellt. Für den Zusammenhang sei auf die Explosionsdarstellung in FIG 6 verwiesen.

FIG 3 zeigt eine 0°-Stellung des Deckels 4 bezogen auf die Baugruppe 1. Der erste Scharnierteil 11 und der zweite Scharnierteil 12 sind geschnitten dargestellt, wobei der Deckel 4 aus einem ersten Deckelteil 4a und einem zweiten Deckelteil 4b besteht. Innerhalb des Deckels 4 verläuft zur Versorgung eines Displays die Flachleitung 42. Die Flachleitung 42 verläuft vom zweiten Scharnierteil 12 in das erste Scharnierteil 11, wo es anschließend mit elektronischen Komponenten der Baugruppe 1 verbindbar ist. Das Federelement 30 ist im ersten Scharnierteil 11 angeordnet, wobei das Federelement 30 eine Welle 20 umschließt, wobei das Federelement 30 zur Ausbildung eines Drehmomentes M beim Öffnen des Deckels 4 und zur Erreichung von Öffnungsstellungen (90°-Stellung, 180°-Stellung) derart ausgebildet ist, dass es eine erste Wellenauflage 31 und eine zweite Wellenauflage 32 aufweist, welche je nach Stellung des Deckels 4 auf die Welle 20 Druck ausüben oder in eine erste Vertiefung 33, eine zweite Vertiefung 34, eine dritte Vertiefung 35 oder in eine vierte Vertiefung 36 der Welle 20 greifen können.

Die Wellenauflage 31 und 32 des Federelementes 30 sind gemäß der Zeichnung derart dargestellt, dass sie in die Welle 20 hineinragen. Dies hat programmtechnische Gründe vom CAD-Programm aber es soll klar sein, dass in der Darstellung gemäß FIG 3 die Wellenauflagen 31,32, direkt auf die Welle 20 drücken und somit Druck für ein Drehmoment erzeugen.

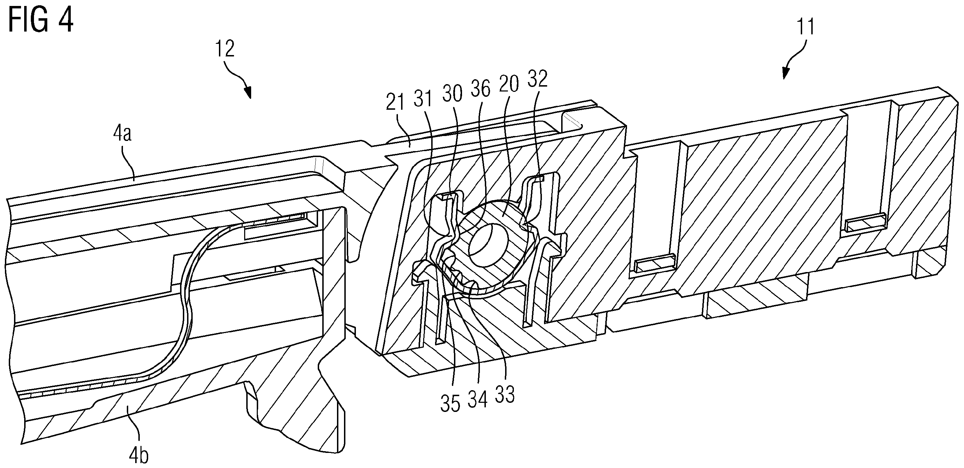

Gemäß FIG 4 ist der Deckel 4 mit seinem ersten Deckelteil 4a und zweiten Deckelteil 4b aufgeklappt dargestellt und zwar aufgeklappt in einer 90°-Stellung. Da die Welle 20 in der ersten Lasche 21 drehfest angeordnet ist, bewegt sich bei einem Aufklappen von einer 0°-Stellung zu einer 90°-Stellung die vierte Vertiefung 36 in Richtung der ersten Wellenauflage 31, wo die Vertiefung 36 letztendlich mit der Wellenauflage 31 verrastet und den Deckel 4 sicher in der 90°-Stellung hält.

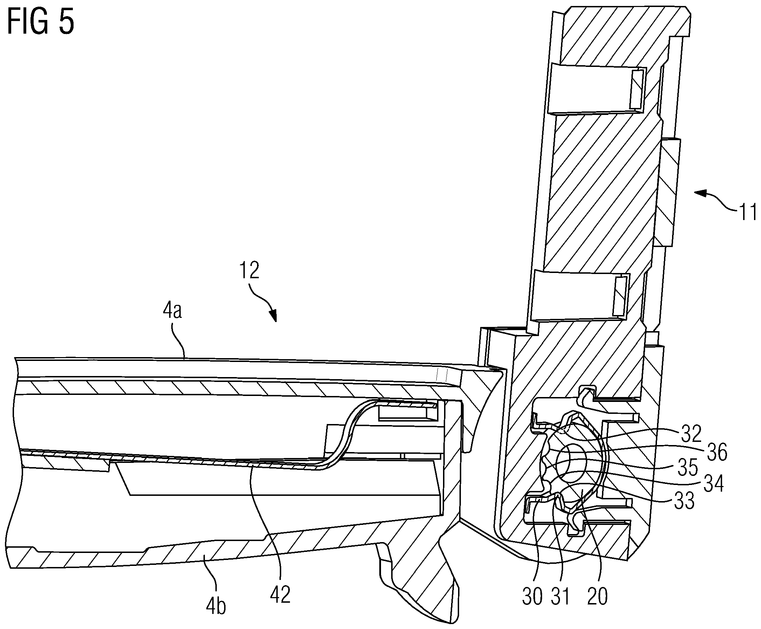

Gemäß der FIG 5 wurde der Deckel 4 gemäß FIG 4 noch einmal um 90° weiter aufgeklappt, wodurch er eine 180°-Stellung erreicht. Durch diese Drehbewegung wird erreicht, dass die erste Vertiefung 33 der Welle 20 sich in Richtung der ersten Wellenauflage 31 bewegt und die erste Wellenauflage 31 mit der ersten Vertiefung 33 verrastet. Das Verrasten der Wellenauflagen 31,32 mit den entsprechenden Vertiefungen 33,34,35, 36 wird erreicht, da das Federelement 30 aus einem flächigen Federmaterial in der Form eines Omega gebogen ist und die erste Wellenauflage 31 und die zweite Wellenauflage 32 des Federelementes 30 als S-förmige Knickstellen in dem flächigen Federmaterial ausgebildet sind.

Die FIG 6 zeigt den ersten Scharnierteil 11 und den zweiten Scharnierteil 12 in einer Explosionsdarstellung. Um die flexible Flachleitung 42, welche den Deckel 4 letztendlich mit der Baugruppe 1 verbindet, bei einem auf- und zuklappen des Deckels 4 sicher zu führen, ist im zweiten Deckelteil 4b ein Spanner 40 mit einer konvexen Gleitfläche 41 zum Führen der flexiblen Flachleitung 42 angeordnet, weiterhin ist am ersten Deckelteil 4a eine Umhausung 43 für den Spanner 40 und die Flachleitung 42 angeordnet.

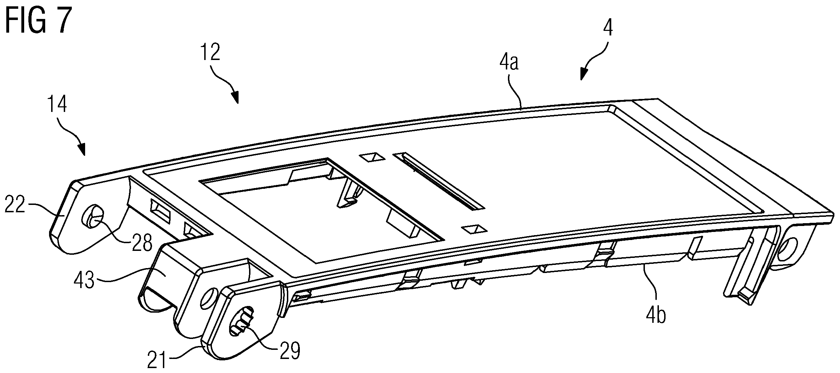

Der Deckel 4 weist zur Ausbildung des zweiten Scharnierteils 12 eine erste Lasche 21 und eine zweite Lasche 22 auf, wobei in der ersten Lasche 21 die Welle 20 drehfest angeordnet ist (siehe auch FIG 7). In der ersten Lasche 21 ist eine Verzahnung 29 für die drehfeste Anordnung der Welle 20 ausgebildet.

Der erste Scharnierteil 11 weist eine erste Gegenlasche 23 und eine zweite Gegenlasche 24 auf, wobei die erste Gegenlasche 23 einen ersten Zapfen 25 aufweist, welcher in einer Bohrung 26 der Welle 20 angeordnet ist, weiterhin weist die zweite Gegenlasche 24 eine Ausnehmung 27 auf, in die ein zweiter Zapfen 28 der zweiten Lasche 22 angeordnet ist, wobei das Federelement 30 die Welle 20 umschließt.

Die FIG 7 zeigt den Deckel 4 mit einem ersten Deckelteil 4a und einen zweiten Deckelteil 4b. In der ersten Lasche 21 ist eine Ausnehmung mit einer Verzahnung 29 für die drehfeste Anordnung der Welle 20 ausgebildet. Die zweite Lasche 22 trägt einen zweiten Zapfen 28, welcher im Eingriff mit der zweiten Gegenlasche 34 steht. Die Umhausung 43 schützt die durch den Deckel 4 in die Baugruppe 1 geführte Flachleitung 42.

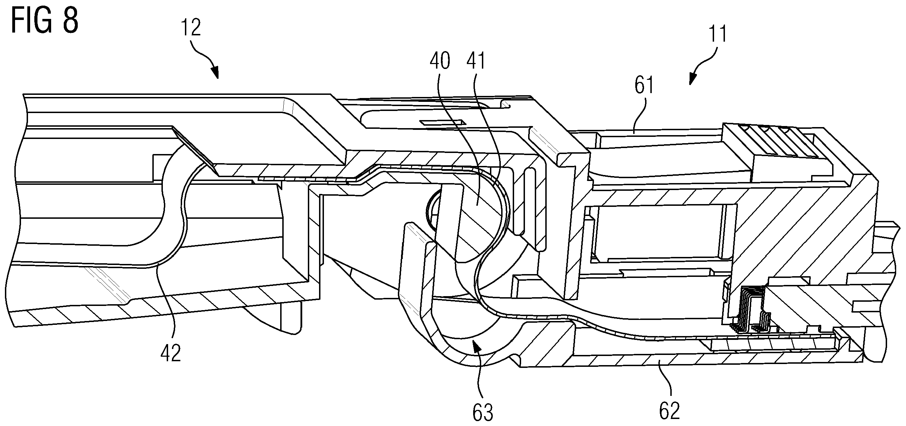

Um die Funktion des Spanners 40 für die Führung der Flachleitung 42 zu verdeutlichen, sind in den Figuren 8, 9, 10 und 11 jeweils der erste und zweite Scharnierteil 11,12 entweder in einer Schnittdarstellung oder in einer halbgeöffneten Darstellung des Deckels 4 dargestellt.

Die FIG 8 zeigt den ersten Scharnierteil 11 und den zweiten Scharnierteil 12 in einer 90°-Darstellung. Die Flachleitung 42 wird durch den Spanner 40 über die konvexe Gleitfläche 41 sicher geführt. Bereits in einer 90°-Stellung setzt die Flachleitung 42 in einer leicht bauchigen Ausbildung in Richtung des Stauraums 63 zu dem "Flügelschlag" an.

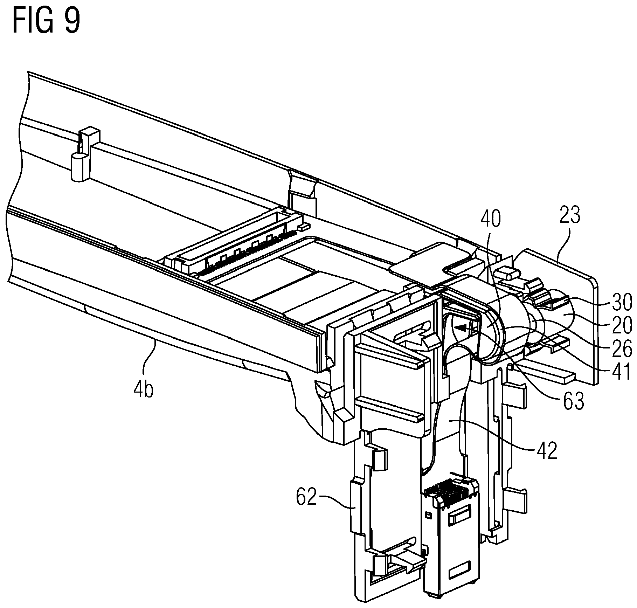

Um die Führung der Flachleitung 42 weiter zu verdeutlichen, ist gemäß FIG 9 die dreidimensionale Ansicht des geöffneten Deckels 4 und des geöffneten ersten Scharnierteils 11 dargestellt.

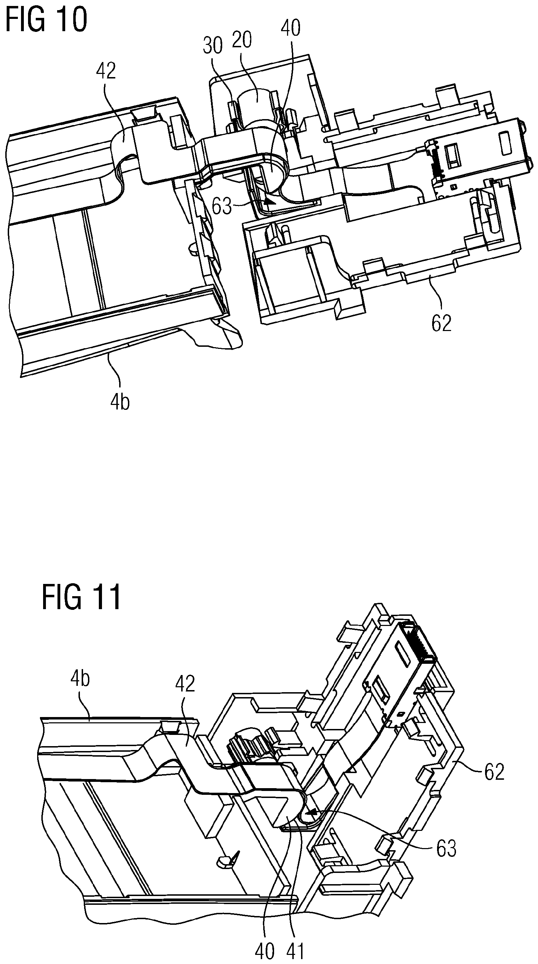

In einer anderen dreidimensionalen Ansicht zeigt die FIG 10 die Führung der Flachleitung 42 durch den Spanner 40, wobei die Flachleitung 42 bei einer 90°-Stellung eine bauchige Ausbildung in Richtung des Stauraumes 63 aufweist.

Wird nun der Deckel 4 von der 90°-Stellung weiter in Richtung einer 180°-Stellung gemäß FIG 11 bewegt, so wird durch den Spanner 40 die Flachleitung 42 weiter bauchig ausgeprägt und in den Stauraum 63 gedrückt, wodurch der "Flügelschlag" der Flachleitung 42 vollendet ist.

## Patentansprüche

1. Elektronische Baugruppe (1) der Automatisierungstechnik mit einem Gehäuse (9), einer Rückseite (2) und einer Vorderseite (3), wobei die Rückseite (2) mit Haltemitteln zum Befestigen an einem Tragsystem ausgestaltet ist und an der Vorderseite (3) ein mit dem Gehäuse (9) verbundener beweglicher Deckel (4) angeordnet ist, wobei in einem oberen Bereich (6) der Vorderseite (3) des Gehäuses (9) eine Aufnahme (7) angeordnet ist, wobei die Aufnahme (7) ausgestaltet ist, ein erstes Scharnierteil (11) eines das Gehäuse (9) und den Deckel (4) verbindenden Scharniers (13) mit einem Verrastmechanismus aufzunehmen, der Deckel (4) ist dabei an einem ersten Ende (14) als ein zweites Scharnierteil (12) des Scharniers (13) ausgestaltet, wobei der Deckel (4) zur Ausbildung des zweiten Scharnierteils (12) eine erste Lasche (21) und eine zweite Lasche(22) aufweist, wobei in der ersten Lasche (21) eine Welle (20) drehfest angeordnet ist, **dadurch gekennzeichnet, dass** der erste Scharnierteil (11) eine erste Gegenlasche (23) und eine zweite Gegenlasche (24) aufweist und die erste Gegenlasche (23) einen ersten Zapfen (25) aufweist, welcher in einer Bohrung (26) der Welle (20) angeordnet ist, weiterhin weist die zweite Gegenlasche (24) eine Ausnehmung (27) auf in die ein zweiter Zapfen (28) der zweiten Lasche (22) angeordnet ist, wobei ein Federelement (30) im ersten Scharnierteil (11) angeordnet ist, wobei das Federelement (30) die Welle (20) umschließt, wobei das Federelement (30) zur Ausbildung eines Drehmoments (11) beim Öffnen des Deckels (4) und zur Erreichung von Öffnungsstellungen derart ausgebildet ist, dass es eine erste Wellenauflage (31) und eine zweite Wellenauflage (32) aufweist, welche je nach Stellung des Deckels (4) auf die Welle (20) Druck ausüben oder in Vertiefungen (33, 34, 35, 36) in der Welle (20) greifen.

2. Elektronische Baugruppe (1) nach Anspruch 1, wobei der Deckel (4) einen ersten Deckelteil (4a) und einen zweiten Deckelteil (4b) umfasst, welche mittels Verraststellen zum bilden des Deckels (4) miteinander verrasten, wobei am zweiten Deckelteil (4b) ein Spanner (40) mit konvexer Gleitfläche (41) zum Führen einer flexiblen Flachleitung (42) angeordnet ist, weiterhin ist am ersten Deckelteil (4a) eine Umhausung (43) für den Spanner (40) und die Flachleitung (42) angeordnet.

3. Elektronische Baugruppe (1) nach Anspruch 2, wobei der erste Scharnierteil (11) ein Oberteil (61) und ein Unterteil (62) umfasst, wobei die erste Gegenlasche (23) und die zweite Gegenlasche (24) am Oberteil (61) angeordnet sind und der Unterteil (62) einen Stauraum (63) für die Flachleitung aufweist.

4. Elektronische Baugruppe (1) nach einem der Ansprüche 1 bis 3, wobei das Federelement (30) aus einem flächigem Federmaterial in der Form eines Omega gebogen ist.

5. Elektronische Baugruppe (1) nach Anspruch 4, wobei die erste Wellenauflage (31) und die zweite Wellenauflage (32) des Federelementes (30) als s-förmige Knickstellen in dem flächigen Federmaterial ausgebildet sind.

## Claims

1. Electronic automation technology module (1) with a housing (9), a rear side (2) and a front side (3), wherein the rear side (2) is configured with retaining means for fastening to a support system and a mobile cover (4) connected to the housing (9) is arranged on the front side (3), wherein in an upper region (6) of the front side (3) of the housing (9) a receptacle (7) is arranged, wherein the receptacle (7) is configured so as to accommodate a first hinge part (11) of a hinge (13) connecting the housing (9) and the cover (4), with a locking mechanism, the cover (4) being configured at a first end (14) as a second hinge part (12) of the hinge (13) in this case, wherein the cover (4) has a first tab (21) and a second tab (22) to form the second hinge part (12), wherein a shaft (20) is arranged in the first tab (21) in a rotationally fixed manner, **characterised in that** the first hinge part (11) has a first countertab (23) and a second countertab (24) and the first countertab (23) has a first pin (25), which is arranged in a borehole (26) of the shaft (20), the second countertab (24) furthermore has a recess (27) in which a second pin (28) of the second tab (22) is arranged, wherein a spring element (30) is arranged in the first hinge part (11), wherein the spring element (30) surrounds the shaft (20), wherein the spring element (30) is embodied to form a torque (11) when opening the cover (4) and to reach opening positions such that it has a first shaft rest (31) and a second shaft rest (32) which, depending on the position of the cover (4), exert pressure on the shaft (20) or engage into depressions (33, 34, 35, 36) in the shaft (20).

2. Electronic module (1) according to claim 1, wherein the cover (4) comprises a first cover part (4a) and a second cover part (4b), which interlock by means of locking points to form the cover (4), wherein a tensioner (40) with a convex sliding surface (41) is arranged on the second cover part (4b) to guiding a flexible flat cable (42), furthermore, an enclosure (43) for the tensioner (40) and the flat cable (42) is arranged on the first cover part (4a).

3. Electronic module (1) according to claim 2, wherein the first hinge part (11) comprises an upper part (61) and a lower part (62), wherein the first countertab (23) and the second countertab (24) are arranged on the upper part (61) and the lower part (62) has a storage space (63) for the flat cable.

4. Electronic module (1) according to one of claims 1 to 3, wherein the spring element (30) is curved from a flat spring material in the form of an omega.

5. Electronic module (1) according to claim 4, wherein the first shaft rest (31) and the second shaft rest (32) of the spring element (30) are embodied as s-shaped bends in the flat spring material.

## Revendications

1. Module (1) électronique de la technique d'automatisation, comprenant un boîtier (9), une face (2) arrière et une face (3) avant, la face (2) arrière étant conformée en ayant des moyens de maintien pour la fixation à un système de support, et un couvercle (4) mobile, relié au boîtier (9) et monté sur la face (3) avant, dans lequel un logement (7) est prévu dans une partie (6) supérieure de la face (3) avant du boîtier (9), le logement (7) étant conformé pour recevoir une première partie (11) d'une charnière (13) reliant le boîtier (9) et le couvercle (4) et ayant un mécanisme d'encliquetage, le couvercle (4) étant conformé à cet effet à une première extrémité (14), comme une deuxième partie (12) de la charnière (13), le couvercle (4) ayant, pour constituer la deuxième partie (12) de la charnière, une première languette (21) et une deuxième languette (22), un arbre (20) étant solidaire en rotation de la première languette (21), **caractérisé en ce que** la première partie (11) de la charnière a une première contre-languette (23) et une deuxième contre-languette (24) et la première contre-languette (23) a un premier tourillon (25), qui est disposé dans un trou (26) de l'arbre (20), en outre, la deuxième contre-languette (24) a un évidement (27), dans lequel est disposé un deuxième tourillon (28) de la deuxième languette (22), un élément (30) de ressort étant disposé dans la première partie (11) de la charnière, l'élément (30) de ressort entourant l'arbre (20), l'élément (30) de ressort étant constitué pour donner un couple (11) à l'ouverture du couvercle (4) et pour obtenir des positions d'ouverture de manière à ce qu'il ait un premier appui (31) d'arbre et un deuxième appui (32) d'arbre, qui, suivant la position du couvercle (4), appliquent de la pression à l'arbre (20) ou pénètrent dans des cavités (33, 34, 35, 36) de l'arbre (20).

2. Module (1) électronique suivant la revendication 1, dans lequel le couvercle (4) comprend une première partie (4a) et une deuxième partie (4b), qui sont encliquetées entre elles au moyen d'endroits d'encliquetage pour former le couvercle (4), dans lequel, sur la deuxième partie (4b) du couvercle est disposé un tendeur (40) à surface (41) de glissement convexe, pour guider un câble (42) plat souple, il est disposé, en outre, sur la première partie (4a) du couvercle, une enveloppe (43) du tendeur (40) et du câble (42) plat.

3. Module (1) électronique suivant la revendication 2, dans lequel la première partie (11) de la charnière comprend une partie (61) supérieure et une partie (62) inférieure, la première contre-languette (23) et la deuxième contre-languette (24) étant disposées à la partie (61) supérieure et la partie (62) inférieure a un espace (63) d'accumulation du câble plat.

4. Module (1) électronique suivant l'une des revendications 1 à 3, dans lequel l'élément (30) de ressort, en un matériau pour ressort plat est incurvé à la forme d'un oméga.

5. Module (1) électronique suivant la revendication 4, dans lequel le premier appui (31) d'arbre et le deuxième appui (32) d'arbre de l'élément (30) de ressort sont constitués sous la forme de points d'inflexion en forme de s dans le matériau de ressort plat.
